# EUROPÄISCHE PATENTANMELDUNG

(11) **EP 2 363 718 A2**
(43) Veröffentlichungstag der Anmeldung: **07.09.2011**
(21) Anmeldenummer: 11000454.6
(22) Anmeldetag: 21.01.2011
(51) Int. Cl.: G01R 1/04, H02G 1/02

(54) **Prüf- und Kurzschlusseinrichtung an isolierten Freileitungsnetzen**

(30) Priorität: 27.01.2010 DE 102010006006
(71) Anmelder: RWE Westfalen-Weser-Ems Netzservice GmbH, 44137 Dortmund (DE)
(72) Erfinder: Hochstein, Willibald Jürgen, 57392 Schmallenberg-Gleidorf (DE)
(74) Vertreter: Polypatent

(57) **Zusammenfassung**

Die Erfindung betrifft eine Prüf- und Kurzschlusseinrichtung an isolierten Freileitungsnetzen. Die erfindungsgemäße Prüf- und Kurzschlusseinrichtung umfasst wenigstens eines Messpunkt an einem Freileitungsmast (1) in Form einer Anschlussgarnitur mit einem Anschlussgehäuse (3), in welches wenigstens einige der Leiter der Freileitung (2) kontaktierbar eingeschleift sind.

## Beschreibung

Die Erfindung betrifft eine Prüf- und Kurzschlusseinrichtung an isolierten Freileitungsnetzen.

Für an Freileitungsnetzen durchzuführende Arbeiten ist für den betreffenden Leitungsabschnitt ein spannungsfreier Zustand herzustellen. Nach festgestellter Spannungsfreiheit, die in der Regel durch eine Messung erfolgt, sind die Leiter des Leitungsabschnitts kurzzuschließen, um einen spannungsfreien Zustand über die Dauer der vorzunehmenden Arbeiten zu gewährleisten.

Bei nichtisolierten Freileitungsnetzen wird üblicherweise eine Kurzschlussgarnitur sichtbar in die Leitung eingehängt, was allerdings bei isolierten Freileitungsnetzen technische Schwierigkeiten bereitet und daher oft nicht durchgeführt wird. Bereits die Feststellung der Spannungsfreiheit mit entsprechenden Messgeräten ist bei isolierten Freileitungsnetzen mit einem gewissen Gefahrenpotential verbunden. Hierzu muss die Isolierung der zu betrachtenden Leitung verletzt werden. Eine zuverlässige Aussage darüber, ob mit der Messeinrichtung die Leitung kontaktiert wurde, ist nicht unter allen Umständen möglich und unter gewissen Witterungsbedingungen, beispielsweise Regen, Schnee, vereister Leitung, mit Risiken verbunden.

Der Erfindung liegt daher die Aufgabe zugrunde, eine Prüf- und Kurzschlusseinrichtung an isolierten Freileitungsnetzen bereitzustellen, die eine sichere Überprüfung des spannungsfreien Zustands der Leitung sowie ein einfaches Kurzschließen derselben ermöglicht.

Die Aufgabe wird gelöst durch eine Prüf- und Kurzschlusseinrichtung an isolierten Freileitungsnetzen, umfassend wenigstens einen Messpunkt an einem Freileitungsmast in Form einer Anschlussgamitur mit einem Anschlussgehäuse in welches wenigstens einige der Leiter der Freileitung kontaktierbar eingeschleift sind.

Auf diese Art und Weise ist es ohne Abisolieren der Freileitungen möglich, an entsprechend vorgesehenen Stellen des Freileitungsnetzes, vorzugsweise an jedem Freileitungsmast eine elektrische Kontaktierung der Leiter des Freileitungsnetzes vorzunehmen, um den spannungsfreien Zustand messen zu können und um gegebenenfalls dort eine Kurzschlussgamitur anlegen zu können. Die vorzugsweise freiliegenden Pole der Leitung sind dafür zweckmäßig in dem Anschlussgehäuse witterungsgeschützt angeordnet.

Bei einer bevorzugten Variante der Prüf- und Kurzschlusseinrlchtung gemäß der Erfindung ist vorgesehen, dass das Anschlussgehäuse Mittel zur Aufnahme einer Kurzschlussbrücke aufweist. Darüber hinaus kann das Anschlussgehäuse mit einem Anschlusspunkt zur Anbringung einer Arbeitserde versehen sein.

Nach einer besonders bevorzugten Variante der Erfindung ist vorgesehen, dass das Anschlussgehäuse mit einem schwenkbar angelenkten, austauschbaren Deckel verschließbar ist und die Anschlussgamitur ferner wenigstens einen mit wenigstens einer Kurzschlussbrücke versehenen Kurzschlussdeckel umfasst, welcher nach Austausch mit dem regulären Deckel durch Einschwenken in die das Anschlussgehäuse verschließende Stellung in die Kurzschlussstellung verbringbar ist

Der an dem Anschlussgehäuse vorgesehene Deckel kann so ausgebildet sein, dass dieser einfach und sicher mittels eines Gestänges aus dem Anschlussgehäuse aushängbar ist und in entsprechender Art und Weise durch einen Kurzschlussdeckel ersetzbar ist. Der Kurzschlussdeckel kann dann mittels eines Gestänges aus sicherer Entfernung in die Kurzschlussstellung verschwenkt werden.

Besonders zweckmäßig ist es, wenn innerhalb des Anschlussgehäuses Mittel zur elektrischer Kontaktierung der eingeschleiften Leiter vorgesehen sind.

Als Mittel zur elektrischen Kontaktierung können innerhalb des Anschlussgehäuses freiliegend angeordnete Kontaktpole vorgesehen sein.

Bei einer vorteilhaften Variante der erfindungsgemäßen Anschlusseinrichtung sind die Kontaktpole jeweils als gabelförmige Kontakte zur Aufnahme von Kontaktmessern oder Kontaktstegen einer Kurzschussbrücke ausgebildet. Die Kurzschlussbrücke kann beispielsweise unverlierbar an der der Innenseite des Anschlussgehäuses zuzuwendenden Seite des Kurzschlussdeckels angeordnet sein.

Das Anschlussgehäuse und der Kurzschlussdeckel sind zweckmäßigerweise aus einem elektrisch isolierenden Material ausgebildet.

Bei einer Variante der Anschlusseinrichtung gemäß der Erfindung ist vorgesehen, dass der Kurzschlussdeckel mit Mitteln zur Signalisierung einer Kurzschlussstellung und/oder einer Messbetriebssteliung versehen ist.

Der Kurzschlussdeckel kann beispielsweise in einer Signalfarbe ausgeführt sein, die sich deutlich von dem Farbton des Deckels des Anschlussgehäuses unterscheidet, so dass der Kurzschlusszustand der des betreffenden Leitungsabschnitts weithin sichtbar ist.

Bei einer besonders günstigen Variante der Prüf- und Kurzschlusseinrichtung gemäß der Erfindung ist vorgesehen, dass an dem Kurzschlussdeckel eine Signalfahne angeordnet ist, die sich bei eingehängtem Kurzschlussdeckel weithin sichtbar in Schwerkraftrichtung erstreckt bzw. herabhängt.

Bei einer bevorzugten Variante der Prüf- und Kurzschlusseinrichtung gemäß der Erfindung ist vorgesehen, dass das Anschlussgehäuse einseitig mit in Einbaulage entgegen der Gewichtskraftrichtung geöffneten Zapfenlagern zur Einhängung von Lagerzapfen eines Deckels oder eines Kurzschlussdeckels versehen ist. Zweckmäßigerweise sind die Zapfenlager jeweils mit einer Kulissenführung zur Führung der Lagerzapfen in ihre Endlage oder aus ihrer Endlage versehen.

Auf der dem Schwenklager der Deckel abgewandten Seite können diese mit einem Rast-/Schnappverschluss versehen sein, der mit Mitteln zur Aufnahme bzw. zum Angriff eines Entriegelungs-/Betätigungsgestänges versehen sein kann.

Ein Ausführungsbeispiel der Erfindung wird nachstehend anhand der beigefügten Zeichnungen beispielsweise erläutert.

Es zeigen:
- Fig. 1: eine schematische Ansicht einer Prüf- und Kurzschlusseinrichtung gemäß der Erfindung an einem Freileitungsmast mit geöffnetem Deckel,
- Fig. 2: eine Ansicht entsprechend der Figur 1 mit eingehängtem Kurzschlussdeckel in kurzgeschlossenem Zustand der Leitung,
- Fig. 3: eine gegenüber den Figuren 2 und 3 um 90° um die Längsachse des Freileitungsmasts gedrehte Ansicht bei eingehängtem und geöffnetem Kurzschlussdeckel und

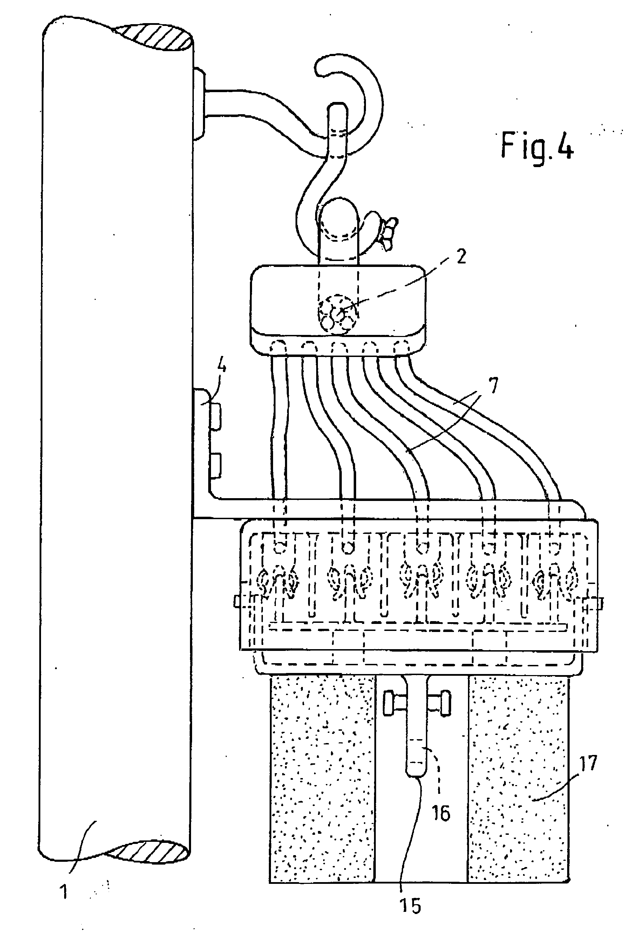

- Fig. 4: eine der Figur 3 entsprechende Ansicht in kurgeschlossenem Zustand.

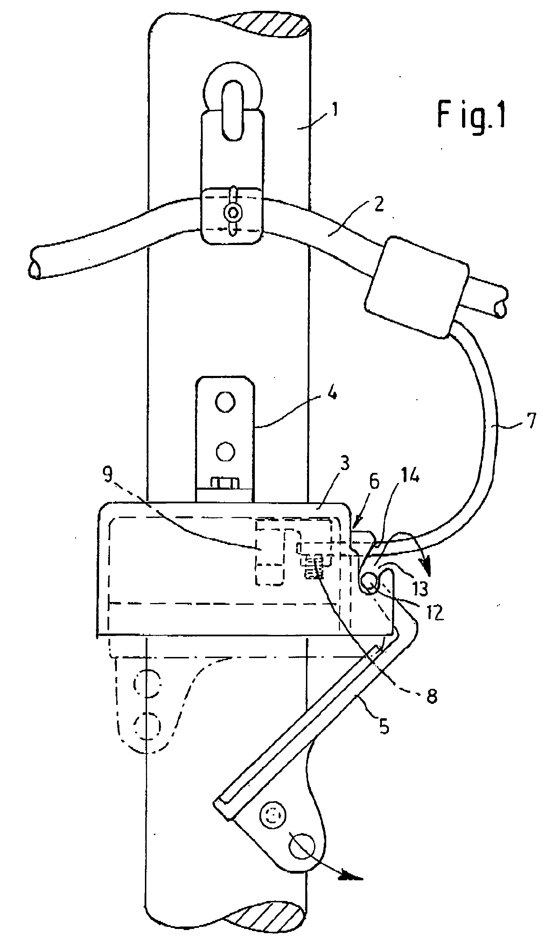

Die Figur 1 zeigt einen Freileitungsmast 1 mit einer an diesem aufgehängten, isolierten Freileitung 2 und einem an dem Freileitungsmast 1 festmontierten Anschlussgehäuse 3, welches Bestandteil der erfindungsgemäßen Prof- und Kurzschlusseinrichtung ist. Das Anschlussgehäuse 3 besteht aus einem witterungsbeständigen Kunststoff und ist im wesentlichen topfförmig ausgebildet sowie mittels eines Winkels 4 mit dem Freileitungsmast 1 verschraubt. Das Anschlussgehäuse 3 ist auf seiner in Einbaulage nach unten weisenden Seite mit einem Deckel 5 verschlossen, der wie nachstehend noch beschrieben wird, einfach abnehmbar in das Anschlussgehäuse 3 eingehängt ist.

Das Anschlussgehäuse 3 ist ferner mit Kabeldurchführungen 6 für Leitungsabzweigungen 7 aus der Freileitung 2 versehen.

Die im Ausführungsbeispiel dargestellte Freileitung 2 umfasst insgesamt fünf Leiter, nämlich drei Phasen, eine Masse und einen Straßenbelauchtungsdraht Alle fünf Leitungen der Frelleitung 2 sind über die Leitungsabzweigungen 7 in das Anschlussgehäuse 3 eingeschleift und über Anschlussklemmen 8 dort freiliegend elektrisch kontaktierbar angeordnet. Hierzu sind innerhalb des Anschlussgehäuses 3 gabelförmige Kontaktpole 9 vorgesehen, die elektrisch mit der jeweiligen Anschlussklemme 8 verbunden sind. Die Anschlussklemmen 8 und die Kontaktpole 9 sind jeweils elektrisch voneinander isoliert.

Mittels eines geeigneten Gestänges (nicht dargestellt) wird der Deckel 5, wie in Figur 1 gezeigt, aufgeschwenkt. Dann sind die Kontaktpole 9 frei zugänglich, so dass an den Kontaktpolen 9 mit einem hierfür geeigneten Messgerät jeweils eine Spannungsmessung vorgenommen werden kann.

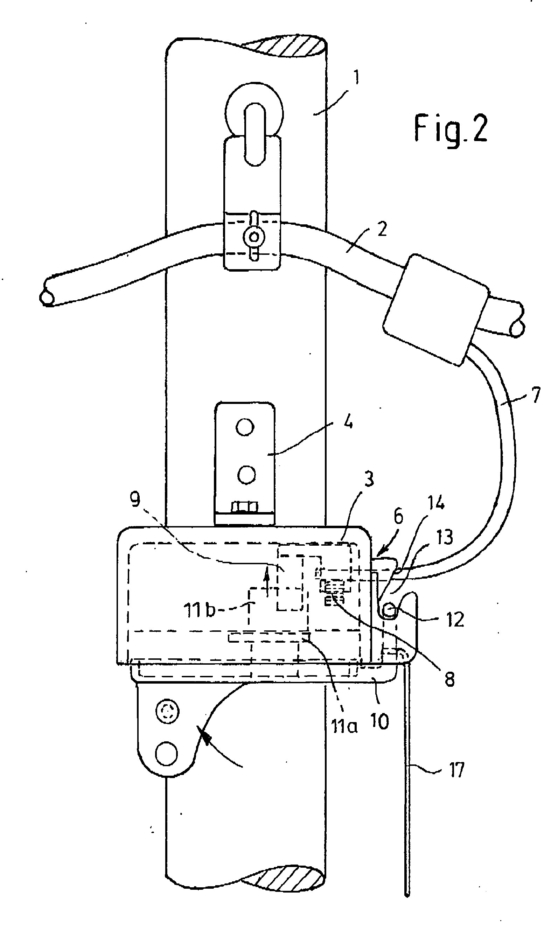

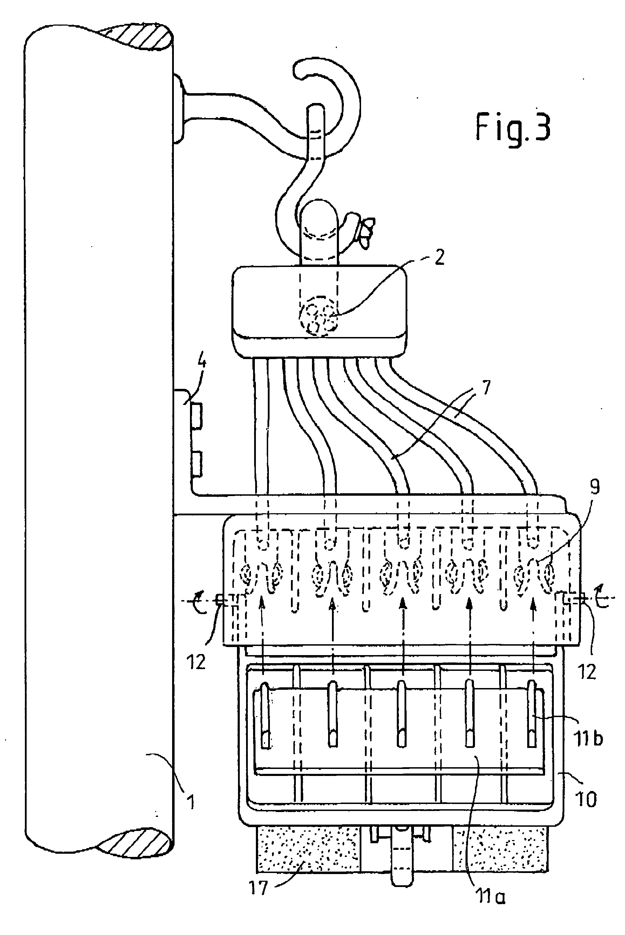

Ist die Spannungsfreiheit der Leiter festgestellt, so kann der Deckel 5 gegen einen Kurzschlussdeckel 10 ausgetauscht werden. Der Kurzschlussdeckel 10 ist beispielsweise in den Figuren 2 und 3 dargestellt.

Der Kurzschlussdeckel ist in Einbaulage auf der den Kontaktpolen 9 zugewandten Innenseite mit einer Kurzschlussbrücke 11a versehen, die entsprechend der Anzahl der Kontaktpole 9, in dem beschriebenen Ausführungsbelspiel fünf, mit Kontaktmessern 11b (Kontaktstegen) versehen ist, die sich in der Kurzschlussstellung des Kurzschlussdeckels 10 (Figur 2) in Eingriff mit den Kontaktpolen 9 befinden, so dass ein allpoliger Kurzschluss der Freileitung 3 bewirkt ist.

Die Kurzschlussbrücke 11a ist unverlierbar an dem Kurzschlussdeckel 10 befestigt.

Sowohl der Deckel 5 als auch der Kurzschlussdeckel 10 sind einseitig mit zwei Lagerzapfen 12 versehen, die jeweils in an einer Seite des Anschlussgehäuses 3 vorgesehene Zapfenlager 13 eingehängt sind. Die Zapfenlager sind in Einbaulage des Anschlussgehäuses 3 entgegen der Schwerkraftrichtung offen sowie mit einer Kulissenführung 14 zur Führung der Lagerzapfen 12 in die Endlage versehen. Die Kulissenführung 14 ermöglicht beispielsweise In der in Figur 1 dargestellten Lage des Deckels 5 ein einfaches Einhängen bzw. Aushängen des Deckels 5. Sodann kann der Deckel 5 ebenso wie auch der Kurzschlussdeckel 10 um die vom Lagerzapfen 12 und Zapfenlager 13 gebildete Scharnierachse in die geschlossene Stellung geschwenkt werden. Die geschlossene Stellung ist beispielsweise in Figur 1 mit gestrichelten Linien gezeichnet.

Auf der von den Lagerzapfen 12 abliegenden Seite des Deckels 5 sowie wie auch des Kurzschlussdeckels 10 sind diese jeweils mit einem nicht dargestellten Rast- bzw. Schnappmechanismus versehen, der hinreichend schwergängig ist, um den Deckel 5 oder auch den Kurzschlussdeckel 10 in der verschlossenen Lage zu halten. Sowohl an dem Deckel 5 als auch an dem Kurzschlussdeckel 10 ist jeweils eine Zunge 15 vorgesehen, die auf deren Außenseite mit einem Eingriffsloch 16 für eine Betätigungsstange versehen ist. So kann beispielsweise gefahrlos ein Öffnen des Deckels 5 mit Abstand zu den Kontaktpolen 9 bewerkstelligt werden. Wesentlich ist, dass die Herstellung eines Kurzschlusses durch Einschwenken des Kurzschlussdeckels 10 in die in Figur 2 dargestellte Lage mit Abstand zu den Kontaktpolen 9 vorgenommen werden kann.

Der Kurzschlussdeckel 10 ist vorzugsweise in einer Signalfarbe ausgeführt, die deutlich verschieden von der Farbe des Deckels 5 bzw. des Anschlussgehäuses 3 ist. Darüber hinaus ist der Kurzschlussdeckel 10 mit einer Signalfahne 17 versehen, die sichtbar herunterhängt, vorzugsweise in den Farben weiß/rot, und die bei hergestelltem Kurzschluss beidseitig sichtbar ist.

Falls Arbeiten an der Freileitung 2 durchgeführt werden müssen, wird diese erst spannungsfrei geschaltet, sodann wird der Deckel 5 des Anschlussgehäuses 3 geöffnet Mit einer geeigneten Messeinrichtung wird der spannungsfreie Zustand aller Kontaktpole 9 bzw. Anschlussklemmen 8 festgestellt. Sodann wird der Deckel 5 gegen den andersfarbigen Kurzschlussdeckel 10 ausgetauscht Aus sicherer Entfernung wird mittels Gestänge ein Kurzschluss hergestellt, d.h. der Kurzschlussdeckel 10 in die in Figur 2 gezeigte Lage verbracht, in der die Kontaktmesser 11 b der Kurzschlussbrücke sich in Eingriff mit den Kontaktpolen 9 befinden.

Nach Abschluss der Arbeiten an der Freileitung wird der Kurzschlussdeckel 10 entfernt und durch den herkömmlichen Deckel 5 ersetzt. Sodann kann die Freileitung 2 wieder unter Spannung gesetzt werden.

### Bezugszeichenliste

- 1: Freileitungsmast
- 2: Freileitung
- 3: Anschlussgehäuse
- 4: Winkel
- 5: Deckel
- 6: Kabeldurchführung
- 7: Leitungsabzweigung
- 8: Anschlussklemmen
- 9: Kontaktpole
- 10: Kurzschlussdeckel
- 11 a: Kurzschlussbrücke
- 11 b: Kontaktmesser
- 12: Lagerzapfen
- 13: Zapfenlager
- 14: Kulissenführung
- 15: Zunge
- 16: Eingriffsloch
- 17: Signalfahne

## Patentansprüche

1. Prüf- und Kurzschlusseinrichtung an isolierten Freileitungsnetzen, umfassend wenigstens einen Messpunkt an einem Freileitungsmast (1) in Form einer Anschlussgarnitur mit einem Anschlussgehäuse (3), in welches wenigstens einige der Leiter der Freileitung (2) kontaktierbar eingeschleift sind.

2. Prüf- und Kurzschlusseinrichtung nach Anspruch 1, **dadurch gekennzeichnet, dass** das Anschlussgehäuse (3) Mittel zur Aufnahme einer Kurzschlussbrücke (11 a) aufweist.

3. Prüf- und Kurzschlusseinrichtung nach einem der Ansprüche 1 oder 2, **dadurch gekennzeichnet, dass** das Anschlussgehäuse (3) mit einem schwenkbar angelenkten, austauschbaren Deckel (5) verschließbar ist und die Anschlussgamitur ferner wenigstens einen mit wenigstens einer Kurzschlussbrücke (11a) versehenen Kurzschlussdeckel (10) umfasst, welcher nach Austausch mit dem Deckel (5) durch Einschwenken in die das Anschlussgehäuse (3) verschließende Stellung in die Kurzschlussstellung verbringbar ist.

4. Prüf- und Kurzschlusseinrichtung nach einem der Ansprüche 1 bis 3, **dadurch gekennzeichnet, dass** innerhalb des Anschlussgehäuse (3) Mittel zur elektrischen Kontaktierung der eingeschleiften Leiter vorgesehen sind.

5. Prüf- und Kurzschlusseinrichtung nach Anspruch 4, **dadurch gekennzeichnet, dass** als Mittel zur elektrischen Kontaktierung innerhalb des Anschlussgehäuses (3) freiliegend anordnete Kontaktpole (9) vorgesehen sind.

6. Prüf- und Kurzschlusseinrichtung nach Anspruch 5, **dadurch gekennzeichnet, dass** die Kontaktpole (9) jeweils als gabelförmige Kontakte zur Aufnahme von Kontaktmessern (11 b) einer Kurzschlussbrücke (11a) ausgebildet sind.

7. Prüf- und Kurzschlusseinrichtung nach einem der Ansprüche 2 bis 6, **dadurch gekennzeichnet, dass** der Kurzschlussdeckel (10) mit Mitteln zur Signalisierung einer Kurzschlussstellung und/oder einer Messbetriebsstellung versehen ist.

8. Prüf- und Kurzschlusseinrichtung nach einem der Ansprüche 2 bis 7, **dadurch gekennzeichnet, dass** der Kurzschlussdeckel (10) in einer Signalfarbe ausgeführt ist.

9. Prüf- und Kurzschlusseinrichtung nach einem der Ansprüche 2 bis 8, **dadurch gekennzeichnet, dass** der Kurzschlussdeckel (10) mit einer Signalfahne (17) versehen ist.

10. Prüf- und Kurzschlusseinrichtung nach einem der Ansprüche 1 bis 9, **dadurch gekennzeichnet, dass** das Anschlussgehäuse (3) einseitig mit in Einbaulage entgegen der Gewichtskraftrichtung geöffneten Zapfenlagern (13) zur Einhängung von Lagerzapfen (12) eines Deckels (5) oder eines Kurzschlussdeckels (10) versehen ist.

11. Prüf- und Kurzschlusseinrichtung nach Anspruch 10, **dadurch gekennzeichnet, dass** die Zapfenlager (13) jeweils mit einer Kulissenführung (14) zur Führung der Lagerzapfen beim Einhängen oder Aushängen des Deckels (5) oder des Kurzschlussdeckels (10) versehen sind.
